# EUROPÄISCHE PATENTSCHRIFT

(11) **EP 3 437 130 B1**
(45) Veröffentlichungstag und Bekanntmachung des Hinweises auf die Patenterteilung: **07.09.2022**
(21) Anmeldenummer: 17713190.1
(22) Anmeldetag: 15.03.2017
(51) Int. Cl.: H01L 21/48, H01L 23/498, H01L 31/0203, H01L 31/173, H01L 23/00, H01L 23/13, H01L 23/552, H01L 25/16, H05K 1/02

(54) **ELEKTRONISCHE EINHEIT**
ELECTRONIC UNIT
UNITÉ ÉLECTRONIQUE

(30) Priorität: 04.04.2016 DE 102016106135
(43) Veröffentlichungstag der Anmeldung: 06.02.2019
(73) Patentinhaber: Vishay Semiconductor GmbH, 74072 Heilbronn (DE)
(72) Erfinder: GEBAUER, Christoph Paul, 74072 Heilbronn (DE); KAMAY, Alexander, 74363 Güglingen-Frauenzimmern (DE)
(74) Vertreter: Manitz Finsterwald Patent- und Rechtsanwaltspartnerschaft mbB
(86) Internationale Anmeldenummer: PCT/EP2017/056155
(87) Internationale Veröffentlichungsnummer: WO 2017/174312

(56) Entgegenhaltungen:
- WO-A2-03/067940
- WO-A2-2006/046221
- JP-A- S61 204 989
- JP-A- 2010 114 114
- JP-U- H0 513 068
- US-A1- 2005 012 574
- US-A1- 2008 237 873
- US-A1- 2013 075 764

## Beschreibung

Die vorliegende Erfindung betrifft eine elektronische Einheit mit zumindest einem ersten elektronischen Bauteil und einem zweiten elektronischen Bauteil, die auf einem Substrat befestigt sind.

Bei der Platzierung von elektronischen Bauteilen auf einem Substrat können sich Probleme ergeben, wenn zumindest eines dieser Bauteile eine elektromagnetische Strahlung emittiert, insbesondere wenn die Bauteile in räumlicher Nähe zueinander angeordnet sind. Diese Strahlung kann möglicherweise die Funktion des anderen Bauteils beeinträchtigen. In manchen Fällen ist es aber nicht zu vermeiden oder aus bestimmten Gründen sogar erwünscht, ein ein elektromagnetische Strahlung emittierendes Bauteil und ein entsprechendes Empfängerbauteil nahe beieinander zu positionieren. In solchen Fällen muss zuverlässig verhindert werden, dass die emittierte Strahlung das Empfängerbauteil direkt beaufschlagt. Zu diesem Zweck kann zwischen den beiden Bauteilen eine Abschirmung vorgesehen sein. Derartige Abschirmungen bekannter Konstruktionsweise sind jedoch vergleichsweise aufwändig und daher teuer in der Herstellung.

Die US 2005/0012574 A1 offenbart eine elektronische Einheit mit den Merkmalen des Oberbegriffs des Anspruchs 1. Die US 2013/0075764 A1 offenbart eine elektronische Einheit mit zwei Ausnehmungen, in denen jeweils ein elektronisches Bauteil angeordnet ist. Eines der Bauteile ist an seiner Oberseite mit einem Draht verbunden, der mit einem Absatz in der zugehörigen Ausnehmung in Kontakt steht.

Die Druckschriften JP H05 13068 U, JP 2010 114114 A und WO 2006/046221 A2 beschreiben weitere elektronische Einheiten mit in Ausnehmungen angeordneten elektronischen Bauteilen. Der wissenschaftliche Artikel von Mickell P. Groover: "Fundamentals of Modern Manufacturing, Materials, Processes, and Systems" In: "Fundamentals of Modern Manufacturing, Materials, Processes, and Systems", 1. Januar 2010 (2010-01-01), XP055450365, ISBN: 978-0-470-46700-8 beschreibt ein Verfahren zur Strukturbildung in Keramiksubstrat.

Es ist eine Aufgabe der vorliegenden Erfindung, eine elektronische Einheit der eingangs genannten Art zu schaffen, die bei einer möglichst kompakten Bauform eine zwischen dem ersten und dem zweiten elektronischen Bauteil angeordnete Abschirmung umfasst, die einfach und kostengünstig herstellbar ist.

Diese Aufgabe wird durch eine elektronische Einheit mit den Merkmalen des Anspruchs 1 gelöst.

Erfindungsgemäß ist die Abschirmung eine aus einer durch das Substrat definierten Ebene ragende oder sich von dessen Oberfläche erstreckende und als Abschirmung fungierende Erhebung vorgesehen, die einstückig mit dem Substrat ausgebildet ist. D.h. die Abschirmung wird zu einem wesentlichen Teil durch das Material des Substrats gebildet und erstreckt sich von dem die Bauteile tragenden Teil des Substrats. Die Erhebung stellt somit eine abschirmende Barriere für die Strahlung dar. Beispielsweise ist die Erhebung eine Art Wall, der zwischen den beiden Bauteilen verläuft und somit die von einem der beiden Teile emittierte Strahlung abschirmt, so dass diese nicht direkt das zweite elektronische Bauteil, beispielsweise ein entsprechendes Sensorbauteil, beaufschlagt. Eine einstückige Bauweise senkt die Herstellungskosten der Einheit. Ein nachträgliches Aufkleben oder Anformen der Erhebung entfällt nämlich.

Die erfindungsgemäße Einheit bildet bevorzugt ein Bauteil, insbesondere SMD-Bauteil, das wiederum in einer größeren elektronischen Einheit, z.B. in einer Schaltung, verbaut wird.

Weitere Ausführungsformen der Erfindung sind in der Beschreibung, den Ansprüchen und den beigefügten Zeichnungen angegeben.

Die Erhebung ist erfindungsgemäß durch ein abtragendes Fertigungsverfahren aus dem Substrat, insbesondere eine Leiterplatte, erzeugt. Beispielsweise wird aus einem Rohling Material des Substrats um die Erhebung herum abgetragen, z.B. durch Ätzen, Fräsen und/oder Laserablation.

Es ist aber grundsätzlich auch möglich, das Substrat mit der Erhebung durch ein spritzgusstechnisches Verfahren zu erzeugen. D.h. das Substrat ist ein sogenannter spritzgegossener Schaltungsträger ("molded interconnect device", MID). Bei dem Spritzgießen des Substrats werden somit die Erhebung sowie - bei Bedarf - weitere Strukturen des Substrats ausgeformt. Dies reduziert die zur Herstellung der räumlichen Struktur des Substrats erforderlichen Verfahrensschritte.

Das Substrat kann auch durch einen 3D-Druck erzeugt werden. Denkbar ist es auch, dass das Substrat aus laminierten Schichten gebildet ist, wobei im Bereich der Erhebung mehr Schichten vorgesehen sind, als in angrenzenden Bereichen des Substrats.

Das erste elektronische Bauteil ist in einer ersten Ausnehmung des Substrats angeordnet und/oder das zweite elektronische Bauteil ist in einer zweiten Ausnehmung des Substrats angeordnet. Dadurch verbessert sich - bei gleicher Höhe - die abschirmende Wirkung der Erhebung. Mit anderen Worten führt die Anordnung eines der Bauteile oder beider Bauteile in entsprechenden, insbesondere separaten Ausnehmungen zu einer verbesserten Abschirmung sowie zu einer Reduzierung der Bauhöhe der elektronischen Einheit.

Das erste elektronische Bauteil und/oder das zweite elektronische Bauteil ist/sind durch ein elektrisch leitendes Kontaktelement, insbesondere ein Draht, mit einer an einem Bodenabschnitt einer dritten Ausnehmung angeordneten Kontaktstelle elektrisch leitend verbunden. Auch diese Maßnahme reduziert die Bauhöhe der elektronischen Einheit, da die Verbindungsstelle des Kontaktelements mit der Kontaktstelle "versenkt" wird. Dabei kann jedes Bauteil mit einer in einer eigenen dritten Ausnehmung angeordneten Kontaktstelle verbunden sein.

Das elektronische Bauteil kann einen Kontaktabschnitt aufweisen, der mit dem Kontaktelement in Verbindung steht und der an einer dem Bodenabschnitt der ersten Ausnehmung abwandten Seite des elektronischen Bauteils angeordnet ist. Die elektronischen Bauteile sind insbesondere Halbleiterbauteile.

Die Erhebung ragt weiter aus der durch das Substrat definierten Ebene heraus als das Kontaktelement. Beispielsweise definiert eine Oberkante der Erhebung die Bauhöhe der Einheit.

Zur Verbesserung der Abschirmwirkung kann die Erhebung zumindest abschnittsweise beschichtet sein, insbesondere mit einem elektromagnetische Strahlung abschirmenden Material. Dadurch kann bewirkt werden, dass die Erhebung im Wesentlichen undurchlässig für die abzuschirmende Strahlung ist. Eine Abschirmung kann beispielsweise auf einer die Strahlung reflektierenden und/oder absorbierenden Wirkung des verwendeten Beschichtungsmaterials beruhen. Elektrisch leitende Materialien haben eine solche abschirmende Wirkung, aber auch eine Reihe nicht-metallischer Materialien, z.B. reflektierende Silikate oder absorbierende organische Verbindungen.

Die erste Ausnehmung, die zweite Ausnehmung und/oder die dritte(n) Ausnehmung(en) können - zusätzlich oder alternativ - zumindest abschnittsweise mit einem elektrisch leitenden Material beschichtet sein. Die Beschichtung der genannten Ausnehmungen kann - falls erforderlich - mit einem Abschnitt der Beschichtung der Erhebung in Kontakt stehen.

Die Erfindung betrifft ferner ein Verfahren zur Herstellung einer elektronischen Einheit, die gemäß einem der vorstehenden Ausführungsformen ausgeführt ist. Das Verfahren umfasst die Schritte:
- Bereitstellen eines Substrats,
- bereichsweises Abtragen oder Entfernen eines Materials des Substrats zur Erzeugung einer aus einer durch das Substrat definierten Ebene ragenden oder sich von dessen Oberfläche erstreckenden und als Abschirmung fungierenden Erhebung, insbesondere durch Fräsen, Ätzen und/oder Laserablation,
- Bestücken des Substrats mit einem ersten elektronischen Bauteil und mit einem zweiten elektronischen Bauteil derart, dass die Erhebung zwischen den beiden elektronischen Bauteilen angeordnet ist.

Ein (nicht erfindungsgemäßes) Verfahren zur Herstellung einer elektronischen Einheit, die insbesondere gemäß einem der vorstehend beschriebenen Ausführungsformen ausgeführt ist, umfasst die Schritte:
- Ausformen eines kunststoffbasierten Substrats durch ein Spritzgussverfahren, so dass eine aus einer durch das Substrat definierten Ebene ragende oder sich von dessen Oberfläche erstreckende und als Abschirmung fungierende Erhebung erzeugt wird, und
- Bestückung des Substrats mit einem ersten elektronischen Bauteil und mit einem zweiten elektronischen Bauteil derart, dass die Erhebung zwischen den beiden elektronischen Bauteilen angeordnet ist.

Ein weiteres (nicht erfindungsgemäßes) Verfahren zur Herstellung einer elektronischen Einheit, die insbesondere gemäß einem der vorstehend beschriebenen Ausführungsformen ausgeführt ist, umfasst die Schritte:
- Ausformen eines kunststoffbasierten Substrats durch ein 3D-Druckverfahren, so dass eine aus einer durch das Substrat definierten Ebene ragende oder sich von dessen Oberfläche erstreckende und als Abschirmung fungierende Erhebung erzeugt wird, und
- Bestückung des Substrats mit einem ersten elektronischen Bauteil und mit einem zweiten elektronischen Bauteil derart, dass die Erhebung zwischen den beiden elektronischen Bauteilen angeordnet ist.

Bei dem 3D-Druck handelt es sich somit um ein "konstruktives" Verfahren zur Erzeugung eines einstückigen Substrats.

Noch ein weiteres "konstruktives" (nicht erfindungsgemäßes) Verfahren zur Herstellung einer elektronischen Einheit, die insbesondere gemäß einem der vorstehend beschriebenen Ausführungsformen ausgeführt ist, umfasst die Schritte:
- Ausformen eines kunststoffbasierten Substrats durch mit einem Bindemittel, insbesondere Harz, verbundene Schichten oder Lagen, insbesondere Gewebematten, so dass eine aus einer durch das Substrat definierten Ebene ragende oder sich von dessen Oberfläche erstreckende und als Abschirmung fungierende Erhebung erzeugt wird, und
- Bestückung des Substrats mit einem ersten elektronischen Bauteil und mit einem zweiten elektronischen Bauteil derart, dass die Erhebung zwischen den beiden elektronischen Bauteilen angeordnet ist.

Die Schichten können vor ihrer Verbindung so zugeschnitten werden, dass sie in einem übereinander gelegten Zustand die gewünschte dreidimensionale Struktur des Substrats ergeben. Insbesondere weist das Substrat im Bereich der Erhebung eine größere Anzahl von Schichten oder Lagen auf, als in angrenzenden Bereichen.

Das vorstehend beschriebene Verfahren umfasst beispielsweise das Laminieren mehrerer Schichten oder Lagen, wie es aus der Herstellung herkömmlicher Leiterplatten bekannt ist.

Mischformen der vorstehend beschriebenen Verfahren sind ebenfalls denkbar, um ein für den jeweiligen Anwendungsfall optimiertes Substrat zu erhalten bzw. um dessen Herstellungskosten zu senken.

All den Verfahren ist jedoch gemeinsam, dass man eine Einheit erhält, bei der die Erhebung ein integraler Bestandteil des Substrats ist. Insbesondere ist die Erhebung aus dem gleichen Material wie der Rest des Substrats. Die Erhebung wird also nicht nachträglich an dem an sich fertigen Substrat befestigt.

Die Erhebung kann zumindest teilweise beschichtet werden, insbesondere mit einem elektromagnetische Strahlung abschirmenden Material.

Nachfolgend wird die vorliegende Erfindung anhand vorteilhafter Ausführungsformen rein beispielhaft unter Bezugnahme auf die beigefügten Zeichnungen erläutert. Es zeigen:
- Fig. 1: einen Querschnitt durch eine elektronische Einheit,
- Fig. 2: einen Querschnitt durch eine elektronische Einheit,
- Fig. 3: eine perspektivische Ansicht einer Ausführungsform der erfindungsgemäßen Einheit,
- Fig. 4 und 5: verschiedene Schnitte durch ein Substrat mit Ausnehmungen,
- Fig. 6 bis 10: weitere Beispiele einer elektronischen Einheit,
- Fig. 11: verschiedene Ausgestaltungen der ersten bzw. zweiten Ausnehmung in zwei Querschnitten,
- Fig. 12 bis 14: eine Ausführungsform eines Herstellungsverfahrens zur Erzeugung der ersten bzw. zweiten Ausnehmung und
- Fig. 15 und 16: noch eine weitere elektronische Einheit in einer Draufsicht bzw. in einem Querschnitt.

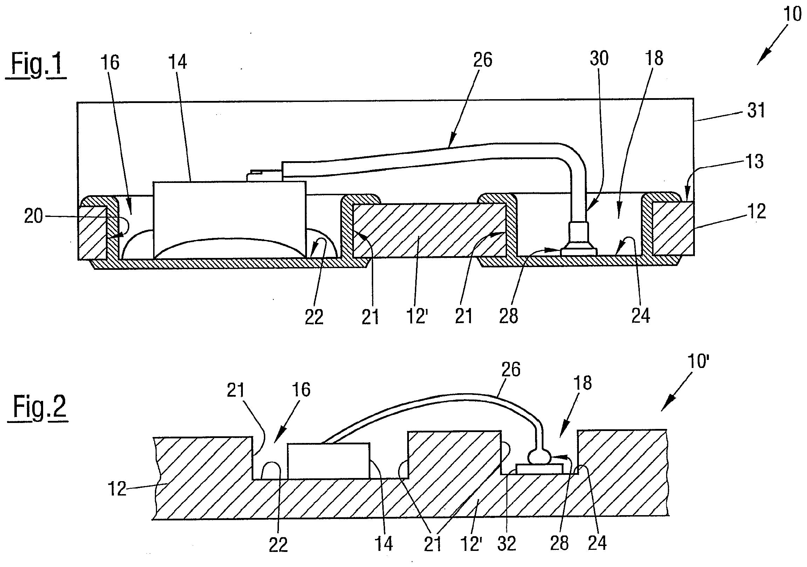

Fig. 1 zeigt eine elektronische Einheit 10, die ein Substrat 12 - konkret eine Leiterplatte - und ein elektronisches Bauteil 14 umfasst. Das elektronische Bauteil 14 ist jedoch nicht auf einer Oberfläche 13 des Substrats 12 angeordnet, sondern in einer Ausnehmung 16, so dass eine Oberkante des Bauteils 14 nur geringfügig über die in Fig. 1 obere Seite bzw. die Oberfläche 13 des Substrats 12 hinausragt. Die Ausnehmung 16 kann auch zumindest so tief sein, dass sie das Bauteil 14 vollständig aufnimmt.

Die Ausnehmung 16 umfasst eine das Substrat 12 durchdringende Durchgangsöffnung 20, die im Zuge eines Beschichtungsprozesses einseitig wieder verschlossen wird. D.h. durch einen Beschichtungsprozess wird in an sich bekannter Weise ein von dem Beschichtungsmaterial gebildeter Bodenabschnitt 22 gebildet. Dabei - oder in einem separaten Schritt - werden auch die Seitenwände der Ausnehmung 16 sowie angrenzende Bereiche der Oberfläche 13 beschichtet. Das Beschichtungsmaterial, die Beschichtungsdicke und/oder die Wahl der beschichteten Abschnitte können an die jeweils vorliegenden Anforderungen angepasst werden.

Das Bauteil 14 kann in herkömmlicher Weise an dem Bodenabschnitt 22 fixiert sein. Dabei kann eine Kontaktierung des Bauteils 14 vorgesehen sein. Es ist aber auch denkbar, dass das Bauteil 14 ohne Herstellung eines elektrischen Kontakts an dem Bodenabschnitt 22 fixiert, insbesondere verklebt, wird.

Das Bauteil 14 ist vorzugsweise ein Halbleiterbauteil. Um das Bauteil 14 mit einem elektrischen Anschluss verbinden zu können, ist ein Draht 26 vorgesehen, der an einer an der Oberseite des Bauteils 14 vorgesehenen Kontaktfläche elektrisch leitend befestigt ist. Die Herstellung der Verbindung zwischen dem Draht 26 und der Kontaktstelle kann beispielsweise durch wedge-bonden erfolgen.

Der Draht 26 stellt eine elektrisch leitende Verbindung 28 mit einem Bodenabschnitt 24 einer zweiten Ausnehmung 18 her. Der Bodenabschnitt 24 ist elektrisch leitend und wurde in ähnlicher/gleicher Weise wie der Bodenabschnitt 22 der Ausnehmung 16 erzeugt. Die Verbindung 28 zwischen dem Draht 26 und dem Bodenabschnitt 22 erfolgt durch "ball-bonden". Der Bodenabschnitt 24 ist somit eine Kontaktstelle für den Draht 26. Die Kontaktstelle kann wiederum über Leiterbahnen oder andere Maßnahmen mit weiteren Anschlüssen in Verbindung stehen, um die Einheit 10 z.B. in eine Schaltung zu integrieren.

Zweckmäßigerweise erfolgt die Herstellung der Verbindung zwischen dem Bauteil 14 und dem Bodenabschnitt 24 in folgender Weise:
Zunächst wird ein Ende des Drahts 26 aufgeschmolzen, so dass sich eine Schmelzkugel (der sogenannte "ball") bildet, der auf die entsprechende Kontaktfläche/-stelle (hier der Bodenabschnitt 24) gedrückt wird. Anschließend wird der Draht 26 zur zweiten Kontaktstelle (hier eine Kontaktfläche an der Oberseite des Bauteils 14) geführt und dort wieder mittels Ultraschall, Wärme und/oder Druck kontaktiert. Das beispielhaft beschriebene Verfahren ist somit ein "reverse ballwedge-bonding-Prozess". Andere Kontaktierungsverfahren können ebenfalls eingesetzt werden. Beispielsweise kann vor dem vorstehend beschriebenen Vorgehen ein "ball" auf der Kontaktstelle an der Oberseite des Bauteils 14 gebildet werden. Der Draht 26 wird dann abgetrennt und anschließend wird der "reverse ballwedge-bonding-Prozess" durchgeführt, wobei der Draht 26 dann nicht direkt an der Kontaktstelle des Bauteils 14 sondern an dem dort befindlichen "ball" fixiert wird (reverse "ball-stitch-on-ball", reverse BSOB).

Da zur Bildung der Schmelzkugel eine erhebliche Menge an Wärme in den Draht 26 eingebracht werden muss, wird ein sich an die Verbindung 28 anschließender Abschnitt 30 des Drahts 26 kurzzeitig thermisch stark belastet. Der Abschnitt 30 ist daher anschließend mechanisch deutlich empfindlicher als thermisch weniger belastete Bereiche des Drahts 26. Das "Versenken" der Verbindung 28 in der Ausnehmung 18 ermöglicht es, den thermisch belasteten Bereich 30 beim Bond-Prozess mechanisch nicht verformen zu müssen. D.h. er kann gerade nach oben "gezogen" werden, ohne dass sich dies negativ auf die Bauhöhe der Gesamtanordnung auswirkt.

Zur Fixierung der Anordnung und zum Schutz von deren Komponenten wird diese mit einem geeigneten Material vergossen (Vergussmasse 31).

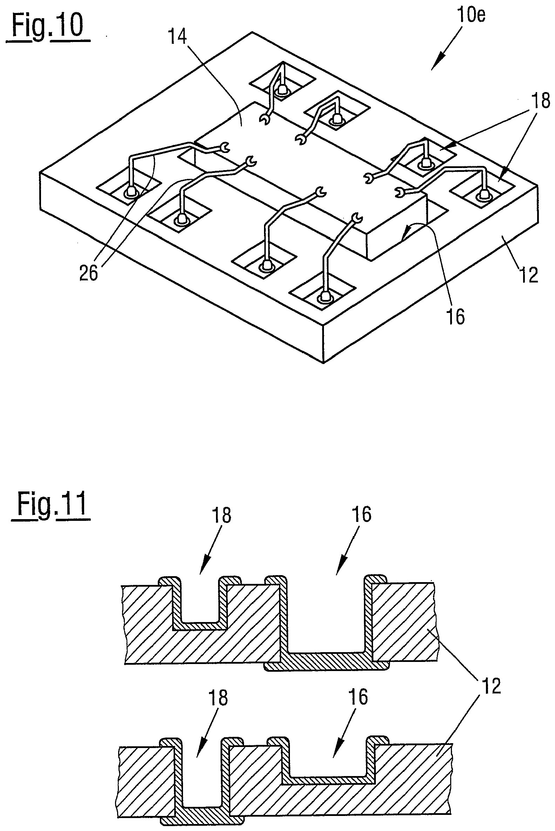

Fig. 2 zeigt eine alternative Ausgestaltung 10' der elektrischen Einheit. Hier liegen keine Durchgangsöffnungen vor, sondern die Bodenabschnitte 22, 24 der Ausnehmungen 16, 18 sind durch das Substrat 12 - hier beispielsweise eine Leiterplatte - selbst gebildet. Die Ausnehmungen 16, 18 sind somit Vertiefungen im Material des Substrats 12. Sie durchdringen das Substrat 12 nicht. Bei einer elektronischen Einheit aus Durchgangsöffnungen erzeugte Ausnehmungen und als Vertiefungen ausgebildete Ausnehmungen zu kombinieren, ist ebenfalls möglich (siehe z.B. Fig. 11). Es versteht sich, dass die Ausnehmungen 16, 18 vollständig oder teilweise beschichtet sein können. Beispielhaft ist gezeigt, dass die Ausnehmung 18 einen teilweise beschichteten Abschnitt (Kontaktstelle 32) aufweist, der in analoger Ausgestaltung zu der in Fig. 1 gezeigten Ausführungsform 10 mit dem Draht 26 verbunden ist.

Um die elektronische Einheit 10' bzw. deren Komponenten zu schützen, wird auch diese mit einer Vergussmasse vergossen (nicht gezeigt).

Der Begriff "Substrat" ist im Rahmen der vorliegenden Offenbarung breit auszulegen. Grundsätzlich ist es möglich, einen Anschluss-Rahmen (lead-frame) entsprechend auszugestalten. Ein Lead-Frame kann auch mehrere getrennte Trägerabschnitte aufweisen, die durch einen Kunststoff miteinander verbunden sind. Bevorzugt ist das Substrat 12 jedoch eine Leiterplatte.

Die Ausnehmungen 16, 18 der Einheiten 10, 10' umfassen Seitenwände 21, die sich allseitig an den jeweiligen Bodenabschnitt 22, 24 anschließen und diesen somit allseitig umgeben. Grundsätzlich ist es denkbar, eine oder mehrere Seiten der Ausnehmungen 16, 18 (teilweise) offen zu lassen. Es ist jedoch bevorzugt, zwischen der Verbindung 28 bzw. der Kontaktstelle 32 und dem Bauteil 14 einen Substratabschnitt 12' vorzusehen. D.h. die entsprechende Ausnehmung 16, 18 weist bevorzugt zumindest eine Seitenwand 21 oder Seitenwandabschnitte auf, die der anderen Ausnehmung 18 bzw. 16 zugewandt sind. Der Substratabschnitt 12' kann im Wesentlichen die gleiche Dicke aufweisen, wie andere, den Ausnehmungen 16, 18 benachbarte Bereiche des Substrats 12.

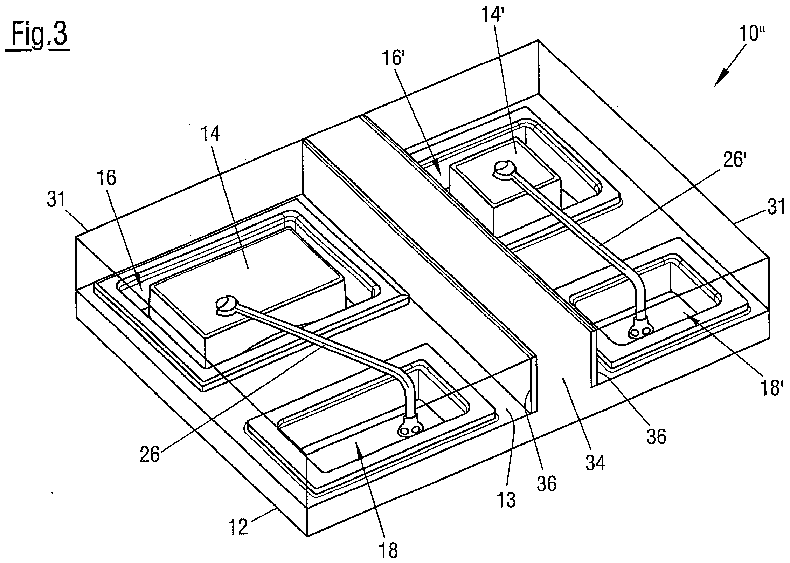

Fig. 3 zeigt eine perspektivische Ansicht einer elektronischen Einheit 10". Die elektronische Einheit 10" umfasst zwei elektronische Bauteile 14, 14', die in Ausnehmungen 16 bzw. 16' angeordnet sind. Sie sind über Drähte 26, 26'jeweils mit einer Kontaktstelle in einer Ausnehmung 18 bzw. 18' bzw. mit dem jeweiligen Bodenabschnitt verbunden. Die Ausnehmungen 16, 16', 18, 18' sind beispielsweise so wie jene in Fig. 1 ausgeführt.

Insbesondere wenn die Bauteile 14, 14' ein elektromagnetische Strahlung emittierendes Senderbauteil und ein entsprechendes Empfängerbauteil sind, ist es sinnvoll bei einer benachbarten Anordnung der Bauteile 14, 14' für eine verlässliche, zwischen den Bauteilen 14, 14' wirkende Abschirmung zu sorgen. Vorliegend wird diese Abschirmung durch einen Wall 34 bereitgestellt, der zwischen den Bauteilen 14, 14' verläuft. Er ist eine Erhebung, die sich aus der Ebene erhebt, die durch das Substrat 12 definiert wird. Oder anders formuliert: Der Wall 32 erstreckt sich von der Oberfläche 13 des Substrats 12.

Der Wall 34 ist einstückig mit dem Substrat 12 verbunden bzw. er ist ein Teil von dem Substrat 12. Dies hat den Vorteil, dass er sich auf einfache Weise herstellen lässt. Beispielsweise wird er durch ein Material abtragendes Fertigungsverfahren aus einem Substratrohling geformt. D.h. die Bereiche um den Wall 34 werden durch ein oder mehrere geeignete Verfahren, wie z.B. Ätzen, Fräsen und/oder Laserablation entfernt. Dabei können auch die Ausnehmungen 16, 18, 16', 18' bzw. entsprechende Durchgangsöffnungen 20 oder das Substrat nicht durchdringende Vertiefungen (siehe z.B. Figs. 2 und 11) gebildet werden.

Es ist aber auch denkbar, das Substrat 12 mit Hilfe der MID-Technik zu formen. Dabei handelt es sich um ein Verfahren, durch das spritzgegossene Schaltungsträger ("molded interconnect devices") erzeugt werden. Bei diesen Schaltungsträgern handelt es sich somit um spritzgegossene Kunststoffteile mit geeignet aufgebrachten metallischen Leiterbahnen und/oder Beschichtungsabschnitten.

Ein weiteres Herstellungsverfahren ist der sog. 3D-Druck. D.h. mittels geeigneter Materialien wird das Substrat 12 schichtweise in der gewünschten Geometrie aufgebaut, so dass die Ausnehmungen 16, 18, 16', 18' und/oder der Wall 34 bedarfsgerecht "konstruktiv" erzeugt werden. Ein abtragender Arbeitsschritt ist dann im Idealfall nicht mehr erforderlich.

Eine ebenfalls "konstruktive" Herstellungsvariante des Substrats 12 sieht eine Laminierung von Lagen mit unterschiedlichen Geometrien vor. Beispielsweise werden Gewebematten geeigneter Formgebung - z.B. mit Öffnungen dort, wo die Ausnehmungen 16, 18, 16', 18' entstehen sollen - übereinander gelegt und mit Harz verbunden. Es ist auch möglich, das Substrat 12 in bestimmten Bereichen dicker zu gestalten - z.B. indem dort eine größere Zahl von Mattenlagen vorgesehen wird -, beispielsweise um den Wall 34 zu bilden.

Auch Mischformen der beschriebenen Verfahren sind möglich. Z. B. kann ein Teilsubstrat durch abtragende Verfahrensschritte gefertigt werden, dass dann auf ein anderes Teilsubstrat (Basis, in der Regel selbst ein laminiertes Bauteil) auflaminiert wird.

Allen Herstellungsvarianten ist gemeinsam, dass ein einstückiges Substrat 12 erhalten wird.

Im vorliegenden Beispiel ist zu erkennen, dass der Wall 34 beidseitig mit einer Beschichtung 36 versehen ist-eine einseitige Beschichtung kann in bestimmten Anwendungsfällen auch ausreichend sein -, die bei Bedarf mit anderen Beschichtungsabschnitten in Verbindung stehen kann. Im vorliegenden Ausführungsbeispiel steht die Beschichtung 36 der linken Seite des Walls 34 mit der Beschichtung der Ausnehmung 16 in Kontakt. Das Material der Beschichtung 36 wird vorzugsweise so gewählt, dass der Wall 34 für die von dem Bauteil 14 und/oder 14' ausgesandte Strahlung undurchdringlich ist bzw. diese zumindest abschwächt.

Der Wall 34 definiert vorzugsweise auch die Oberkante der Vergussmasse 31, um eine kompakte Baueinheit ohne vorstehende Kanten zu bilden.

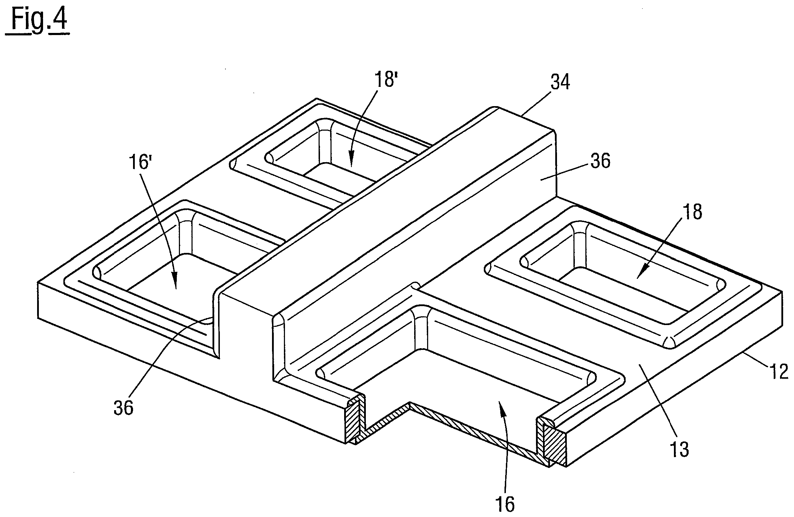

Fig. 4 zeigt das mit dem Wall 34 versehene Substrat 12 in einer perspektivischen Ansicht ohne die Bauteile 14, 14' oder Drähte 26, 26'. Die Ausnehmung 16 ist teilweise aufgeschnitten dargestellt, um zu zeigen, dass sie im Wesentlichen so ausgestaltet ist, wie es anhand der Fig. 1 erläutert wurde.

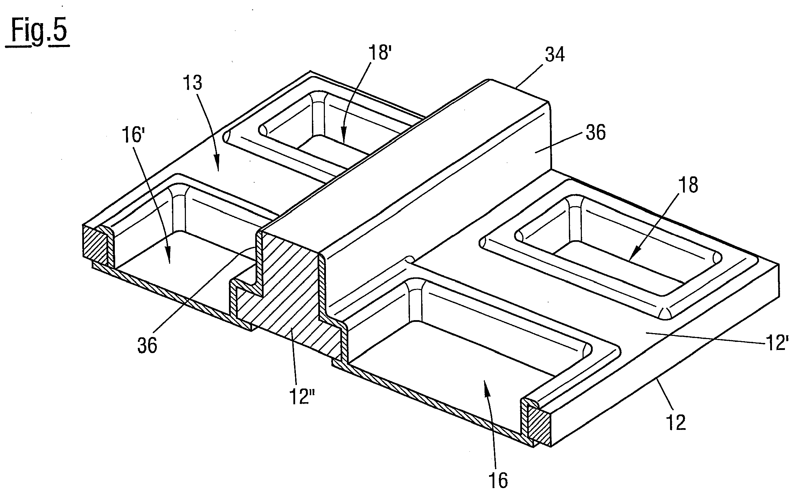

Fig. 5 zeigt das Substrat 12 der Fig. 4 in einem vollständigen Schnitt, so dass auch der Aufbau des Walls 34 erkennbar ist, der sich von einem zwischen den Ausnehmungen 16, 16' angeordneten Substratabschnitt 12" erstreckt. Das Substrat 12 und der Wall 34 sind einstückig ausgebildet. Der Wall 34 weist eine beidseitige Beschichtung 36 auf, die mit den jeweiligen Beschichtungen der Ausnehmungen 16' (links) bzw. 16 (rechts) in Verbindung stehen.

Der Gedanke eines Strahlung abschirmenden Walls kann unabhängig von dem Gedanken realisiert werden, das elektronische Bauteil und die Kontaktstelle in separaten Ausnehmungen zu platzieren.

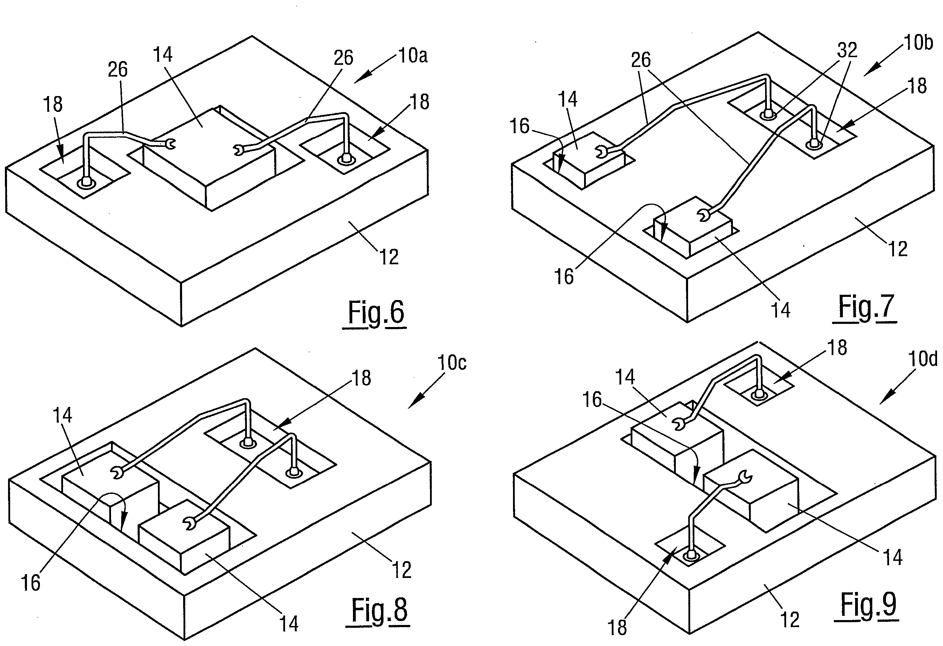

Fig. 6 bis 10 zeigen beispielhaft, wie vielfältig mögliche Ausführungsformen der erfindungsgemäßen elektronischen Einheit ausgestaltet sein können.

Eine Einheit 10a umfasst z.B. zwei Ausnehmungen 18, die jeweils zur Kontaktierung eines der beiden Drähte 26 dienen, die beide mit dem Bauteil 14 verbunden sind (vgl. Fig. 6).

Im Gegensatz dazu weist eine Einheit 10b zwei Bauteile 14 auf, die jeweils in einer eigenen Ausnehmung 16 angeordnet sind und die jeweils mit einem Draht 26 in Verbindung stehen. Die Drähte 26 sind wiederum mit eigenen Kontaktstellen 32 verbunden, die in einer gemeinsamen Ausnehmungen 18 angeordnet sind (vgl. Fig. 7).

Eine Einheit 10c unterscheidet sich von der Einheit 10b dadurch, dass die Bauteile 14 in einer gemeinsamen Ausnehmung 16 angeordnet sind (vgl. Fig. 8).

Bei einer Einheit 10d sind zwar - wie bei der Einheit 10c - die Bauteile 14 in einer gemeinsamen Ausnehmung 16 angeordnet. Allerdings sind - wie bei der Einheit 10a - zwei separate Ausnehmungen 18 vorgesehen (vgl. Fig. 9).

Eine Einheit 10e weist ein Bauteil 14 auf, dass in einer eigenen Ausnehmung 16 angeordnet ist (vgl. Fig. 10). An ihm sind 8 Drähte 26 befestigt, die wiederum mit eigenen Kontaktstellen 32 verbunden sind, die in 8 separaten Ausnehmungen 18 angeordnet sind.

Mischformen der vorstehend beschriebenen Ausführungsformen sind ohne weiteres möglich. Die Anzahl und Ausgestaltung (z.B. Geometrie, Beschichtung, ...) der Ausnehmungen 16, 18 kann an die jeweils vorliegenden Anforderungen angepasst werden, wie beispielweise der Fig. 11 zu entnehmen ist. Hier weisen die Ausnehmungen 16, 18 unterschiedliche Tiefen auf.

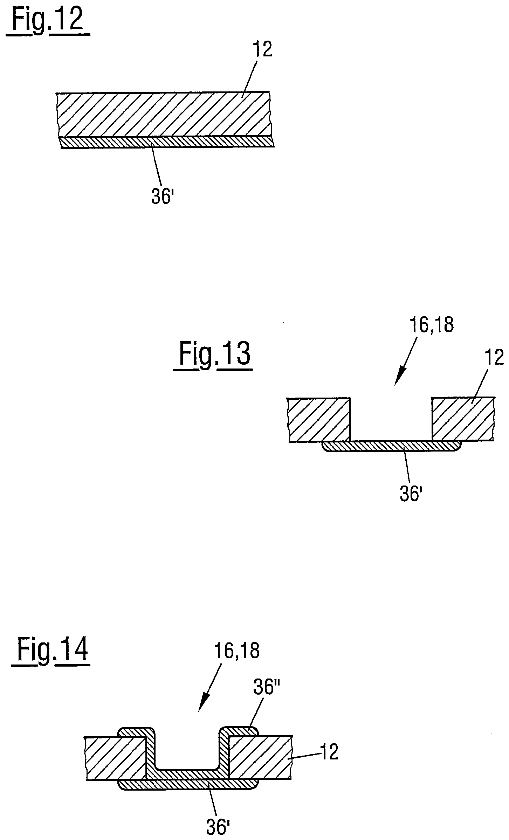

Anhand der Fig. 12 bis 14 wird nachstehend eine Variante zur Herstellung einer Ausführungsform der Ausnehmung 16, 18 beschrieben.

Fig. 12 zeigt ein einseitig beschichtetes Substrat 12. Die Beschichtung 36' ist beispielsweise eine Metallschicht. Durch ein materialabtragendes Verfahren wird die Ausnehmung 16, 18 in das Substrat 12 eingebracht. Vorzugsweise ist das Verfahren ein Laserablationsverfahren. Wenn die Beschichtung 36' metallisch ist (z.B. Cu), kommt das Abtragen automatisch zu einem Ende, wenn das Substrat 12 vollständig durchdrungen wurde (siehe Zustand in Fig. 13). Falls der verwendete Laser nicht zu stark ist, wird der einfallende Laserstrahl nämlich reflektiert, sobald er auf die dem Substrat zugewandte Oberfläche der Beschichtung 36' trifft. Die Beschichtung 36' kann bei Bedarf bereichsweise entfernt werden (siehe Fig. 13).

Optional wird anschließend eine Beschichtung 36" aufgebracht, die die Ausnehmung 16, 18 teilweise oder vollständig auskleidet (siehe Fig. 14). Bei Bedarf kann - gleichzeitig mit dem Auftragen der Beschichtung 36" oder in einem separaten Schritt - auch die Beschichtung 36' - teilweise oder ganz - beschichtet bzw. überdeckt werden. Das Material der Beschichtungen 36', 36" kann gleich oder unterschiedlich sein.

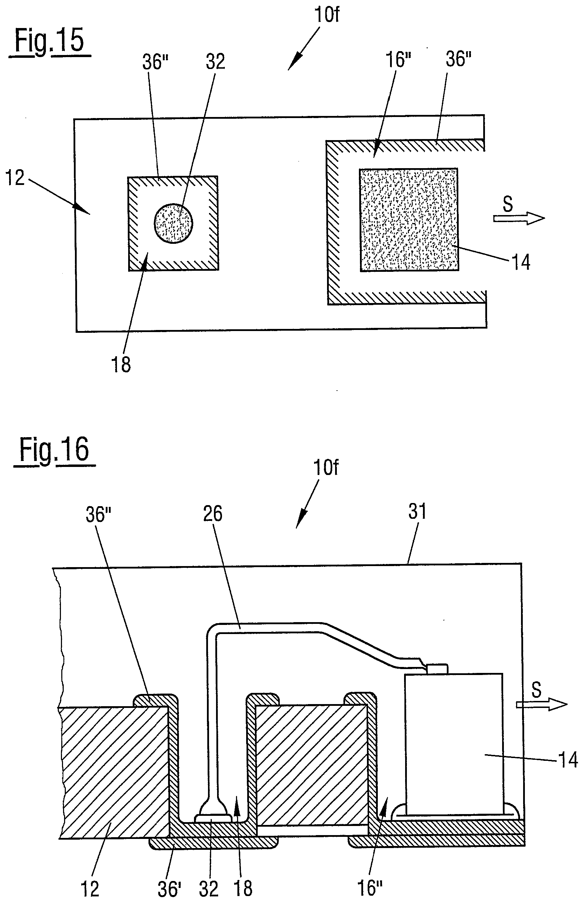

Fig. 15 zeigt eine Einheit 10f mit einem Bauteil 14 (z.B. eine LED), dass in einer einseitig offenen, beschichteten (Beschichtung 36") Ausnehmung 16" angeordnet ist. Dadurch kann das Bauteil 14 ungehindert elektromagnetische Strahlung S nach rechts abgeben. Ein mit dem Bauteil 14 verbundener Bonddraht 26 steht mit einer in einer in Umfangsrichtung geschlossenen Ausnehmung 18 angeordneten Kontaktstelle 32 in Verbindung (siehe auch Fig. 16). Die Komponenten der Einheit 10f und insbesondere deren elektrische Kontaktierung werden duch eine Vergussmasse 31 geschützt.

### Bezugszeichenliste

- 10, 10', 10", 10a-10f: elektronische Einheit
- 12: Substrat
- 12', 12": Substratabschnitt
- 13: Oberfläche
- 14, 14': elektronisches Bauteil
- 16, 16', 16": Ausnehmung
- 18, 18': Ausnehmung
- 20: Durchgangsöffnung
- 21: Seitenwand
- 22, 24: Bodenabschnitt
- 26, 26': Draht
- 28: Verbindung
- 30: Drahtabschnitt
- 31: Vergussmasse
- 32: Kontaktstelle
- 34: Wall
- 36, 36', 36": Beschichtung
- S: Strahlung

## Patentansprüche

1. Elektronische Einheit mit zumindest einem ersten elektronischen Bauteil (14) und einem zweiten elektronischen Bauteil (14'), die auf einem Substrat (12) befestigt sind, wobei zwischen dem ersten und dem zweiten elektronischen Bauteil (14, 14') eine Abschirmung angeordnet ist, die eine aus einer durch das Substrat definierten Ebene ragende oder sich von dessen Oberfläche erstreckende und als Abschirmung fungierende Erhebung (34) umfasst, die einstückig mit dem Substrat (12) ausgebildet ist,
wobei die Erhebung (34) durch ein abtragendes Fertigungsverfahren aus dem Substrat (12) geformt ist und dass die Erhebung (34) weiter aus der durch das Substrat (12) definierten Ebene ragt oder sich weiter von dessen Oberfläche erstreckt als ein Kontaktelement (26, 26') zur Kontaktierung des ersten oder zweiten elektronischen Bauteils (14 bzw. 14'), wobei das erste elektronischen Bauteil (14) in einer ersten Ausnehmung (16) des Substrats (12) angeordnet ist und/oder das zweite elektronische Bauteil (14') in einer zweiten Ausnehmung des Substrats (12) angeordnet ist,
**dadurch gekennzeichnet, dass**
das erste elektronische Bauteil (14) und/oder das zweite elektronische Bauteil (14') durch ein elektrisch leitendes Kontaktelement (26, 26'), das mit an einer an einer Oberseite des ersten oder zweiten Bauteils (14, 14') vorgesehenen Kontaktfläche elektrisch leitend verbunden ist, mit einer an einem Bodenabschnitt (24) einer dritten Ausnehmung (18, 18') angeordneten Kontaktstelle (32) elektrisch leitend verbunden ist und wobei die erste und/oder die zweite Ausnehmung (16) und die dritte Ausnehmung (18, 18') gleiche Tiefen aufweisen, wobei die Ausnehmungen (16, 18, 18') Durchgangsöffnungen (20) sind, die durch einen Beschichtungsprozess einseitig verschlossen sind.

2. Elektronische Einheit nach einem der vorhergehenden Ansprüche,
**dadurch gekennzeichnet, dass**
das abtragende Fertigungsverfahren Ätzen, Fräsen und/oder Laserablation umfasst.

3. Elektronische Einheit nach einem der vorhergehenden Ansprüche,
**dadurch gekennzeichnet, dass**
das elektrisch leitende Kontaktelement (26, 26') ein Draht ist.

4. Elektronische Einheit nach einem der vorhergehenden Ansprüche,
**dadurch gekennzeichnet, dass**
die Erhebung (34) zumindest teilweise beschichtet ist.

5. Elektronische Einheit nach Anspruch 4,
**dadurch gekennzeichnet, dass**
die Erhebung (34) zumindest teilweise mit einem elektromagnetische Strahlung abschirmenden Material beschichtet ist.

6. Elektronische Einheit nach einem der vorhergehenden Ansprüche,
**dadurch gekennzeichnet, dass**
die erste Ausnehmung (16), die zweite Ausnehmung (16') und/oder die dritte Ausnehmung (18, 18') zumindest abschnittsweise mit elektrisch leitendem Material beschichtet sind.

7. Elektronische Einheit nach Anspruch 5 oder 6,
**dadurch gekennzeichnet, dass**
eine Beschichtung der ersten Ausnehmung (16), der zweiten Ausnehmung (16') und/oder die dritte Ausnehmung (18, 18') mit einem Abschnitt der Beschichtung (36) der Erhebung (34) in Kontakt steht.

8. Elektronische Einheit nach einem der vorhergehenden Ansprüche,
**dadurch gekennzeichnet, dass**
das erste elektronische Bauteil (14) und/oder das zweite elektronische Bauteil (14') Halbleiterbauteile sind.

9. Elektronische Einheit nach einem der vorhergehenden Ansprüche,
**dadurch gekennzeichnet, dass**
das erste elektronische Bauteil (14) eine elektromagnetische Strahlung emittierendes Bauteil und das zweite elektronische Bauteil (14') ein elektromagnetische Strahlung detektierendes Bauteil ist.

10. Verfahren zur Herstellung einer elektronischen Einheit, die gemäß einem der vorstehenden Ansprüche ausgeführt ist, umfassend die Schritte:
- Bereitstellen eines Substrats (12),
- bereichsweises Abtragen eines Materials des Substrats (12) zur Erzeugung einer aus einer durch das Substrat definierten Ebene ragenden oder sich von dessen Oberfläche erstreckenden und als Abschirmung fungierenden Erhebung (34), derart dass die Erhebung (34) weiter aus der durch das Substrat (12) definierten Ebene ragt oder sich weiter von dessen Oberfläche erstreckt als ein Kontaktelement (26, 26') zur Kontaktierung des ersten oder zweiten elektronischen Bauteils (14 bzw. 14'), und
- Bestückung des Substrats (12) mit einem ersten elektronischen Bauteil (14) und mit einem zweiten elektronischen Bauteil (14') derart, dass die Erhebung (34) zwischen den beiden elektronischen Bauteilen angeordnet ist.

11. Verfahren nach Anspruch 10,
**dadurch gekennzeichnet, dass**
das Abtragen durch Fräsen, Ätzen und/oder Laserablation erfolgt.

12. Verfahren nach Anspruch 10 oder 11,
**dadurch gekennzeichnet, dass**
die Erhebung (34) zumindest teilweise beschichtet wird.

13. Verfahren nach Anspruch 12,
**dadurch gekennzeichnet, dass**
die Erhebung (34) zumindest teilweise mit einem elektromagnetische Strahlung abschirmenden Material beschichtet wird.

## Claims

1. An electronic unit having at least a first electronic component (14) and a second electronic component (14') which are fastened to a substrate (12), wherein a shielding is arranged between the first and second electronic components (14, 14') that comprises an elevated portion (34) which projects from a plane defined by the substrate or which extends from its surface, which acts as a shielding and which is formed in one piece with the substrate (12),
wherein the elevated portion (34) is formed from the substrate (12) by a stripping production method, and in that the elevated portion (34) projects further from the plane defined by the substrate (12) or extends further from its surface than a contact element (26, 26') for contacting the first or second electronic component (14 or 14'), wherein the first electronic component (14) is arranged in a first recess (16) of the substrate (12) and/or the second electronic component (14') is arranged in a second recess of the substrate (12),
**characterized in that**
the first electronic component (14) and/or the second electronic component (14') is/are electrically conductively connected by an electrically conductive contact element (26, 26'), which is electrically conductively connected to a contact surface provided at an upper side of the first or second component (14, 14'), to a contact point (32) arranged at a base section (24) of a third recess (18, 18'), and with the first and/or second recess (16) and the third recess (18, 18') having the same depths, with the recesses (16, 18, 18') being passage openings (20) which are closed at one side by a coating process.

2. An electronic unit in accordance with one of the preceding claims,
**characterized in that**
the stripping production method comprises etching, milling and/or laser ablation.

3. An electronic unit in accordance with one of the preceding claims,
**characterized in that**
the electrically conductive contact element (26, 26') is a wire.

4. An electronic unit in accordance with any one of the preceding claims, **characterized in that**
the elevated portion (34) is at least partly coated.

5. An electronic unit in accordance with claim 4,
**characterized in that**
the elevated portion (34) is at least partly coated with a material shielding electromagnetic radiation.

6. An electronic unit in accordance with any one of the preceding claims,
**characterized in that**
the first recess (16), the second recess (16') and/or the third recess (18, 18') is/are at least sectionally coated with an electrically conductive material.

7. An electronic unit in accordance with claim 5 or claim 6,
**characterized in that**
a coating of the first recess (16), of the second recess (16') and/or of the third recess (18, 18') is in contact with a section of the coating (36) of the elevated portion (34).

8. An electronic unit in accordance with any one of the preceding claims,
**characterized in that**
the first electronic component (14) and/or the second electronic component (14') is/are semiconductor components.

9. An electronic unit in accordance with any one of the preceding claims,
**characterized in that**
the first electronic component (14) is a component emitting electromagnetic radiation and the second electronic component (14') is a component detecting electromagnetic radiation.

10. A method of manufacturing an electronic unit which is designed in accordance with any one of the preceding claims, comprising the steps:
- providing a substrate (12);
- regionally stripping a material of the substrate (12) for producing an elevated portion (34) which projects from a plane defined by the substrate or which extends from its surface and which acts as a shielding such that the elevated portion (34) projects further from the plane defined by the substrate (12) or extends further from its surface than a contact element (26, 26') for contacting the first or second electronic component (14 or 14'); and
- mounting the substrate (12) with a first electronic component (14) and a second electronic component (14') such that the elevated portion (34) is arranged between the two electronic components.

11. A method in accordance with claim 10,
**characterized in that**
the stripping takes place by milling, etching and/or laser ablation.

12. A method in accordance with claim 10 or claim 11,
**characterized in that**
the elevated portion (34) is at least partly coated.

13. A method in accordance with claim 12,
**characterized in that**
the elevated portion (34) is at least partly coated with a material shielding electromagnetic radiation.

## Revendications

1. Unité électronique comprenant au moins un premier composant électronique (14) et un deuxième composant électronique (14') qui sont fixés sur un substrat (12), un blindage étant disposé entre les premier et deuxième composants électroniques (14, 14'), lequel comprend un bossage (34) qui fait saillie d'un plan défini par le substrat ou qui s'étend à partir de sa surface et qui sert de blindage, lequel bossage est réalisé d'une seule pièce avec le substrat (12),
dans laquelle
le bossage (34) est formé à partir du substrat (12) par un procédé de fabrication par enlèvement de matière, et le bossage (34) fait saillie plus loin du plan défini par le substrat (12) ou s'étend plus loin à partir de sa surface qu'un élément de contact (26, 26') pour la mise en contact du premier ou du deuxième composant électronique (14 ou 14'), le premier composant électronique (14) étant disposé dans un premier évidement (16) du substrat (12) et/ou le deuxième composant électronique (14') étant disposé dans un deuxième évidement du substrat (12),
**caractérisée en ce que**
le premier composant électronique (14) et/ou le deuxième composant électronique (14') est relié de manière électriquement conductrice à un emplacement de contact (32), situé sur une portion de fond (24) d'un troisième évidement (18, 18'), par un élément de contact électriquement conducteur (26, 26') relié de manière électriquement conductrice à une surface de contact prévue sur une face supérieure du premier ou du deuxième composant (14, 14'), et le premier et/ou le deuxième évidement (16) et le troisième évidement (18, 18') présentent des profondeurs identiques, les évidements (16, 18, 18') étant des ouvertures traversantes (20) qui sont fermées d'un côté par un processus de revêtement.

2. Unité électronique selon la revendication précédente,
**caractérisée en ce que**
le procédé de fabrication par enlèvement de matière inclut la gravure, le fraisage et/ou l'ablation au laser.

3. Unité électronique selon l'une des revendications précédentes,
**caractérisée en ce que**
l'élément de contact électriquement conducteur (26, 26') est un fil.

4. Unité électronique selon l'une des revendications précédentes,
**caractérisée en ce que**
le bossage (34) est au moins partiellement revêtu.

5. Unité électronique selon la revendication 4,
**caractérisée en ce que**
le bossage (34) est revêtu au moins partiellement d'un matériau de blindage contre le rayonnement électromagnétique.

6. Unité électronique selon l'une des revendications précédentes,
**caractérisée en ce que**
le premier évidement (16), le deuxième évidement (16') et/ou le troisième évidement (18, 18') sont revêtus au moins localement d'un matériau électriquement conducteur.

7. Unité électronique selon la revendication 5 ou 6,
**caractérisée en ce que**
un revêtement du premier évidement (16), du deuxième évidement (16') et/ou du troisième évidement (18, 18') est en contact avec une portion du revêtement (36) du bossage (34).

8. Unité électronique selon l'une des revendications précédentes,
**caractérisée en ce que**
le premier composant électronique (14) et/ou le deuxième composant électronique (14') sont des composants semi-conducteurs.

9. Unité électronique selon l'une des revendications précédentes,
**caractérisée en ce que**
le premier composant électronique (14) est un composant émettant un rayonnement électromagnétique, et le deuxième composant électronique (14') est un composant détectant un rayonnement électromagnétique.

10. Procédé de fabrication d'une unité électronique réalisée selon l'une des revendications précédentes, comprenant les étapes consistant à :
- fournir un substrat (12),
- enlever localement un matériau du substrat (12) pour produire un bossage (34) qui fait saillie d'un plan défini par le substrat ou qui s'étend à partir de sa surface et qui sert de blindage, de telle sorte que le bossage (34) fait saillie plus loin du plan défini par le substrat (12) ou s'étend plus loin à partir de sa surface qu'un élément de contact (26, 26') pour la mise en contact du premier ou du deuxième composant électronique (14 ou 14'), et
- équiper le substrat (12) d'un premier composant électronique (14) et d'un deuxième composant électronique (14') de telle sorte que le bossage (34) est disposé entre les deux composants électroniques.

11. Procédé selon la revendication 10,
**caractérisé en ce que**
l'enlèvement de matière est réalisé par fraisage, gravure et/ou ablation au laser.

12. Procédé selon la revendication 10 ou 11,
**caractérisé en ce que**
le bossage (34) est revêtu au moins partiellement.

13. Procédé selon la revendication 12,
**caractérisé en ce que**
le bossage (34) est revêtu au moins partiellement d'un matériau de blindage contre le rayonnement électromagnétique.
